(19) Europäisches Patentamt

European Patent Office

Office européen des brevets

(11) **EP 0 910 164 B1**

(12) **EUROPEAN PATENT SPECIFICATION**

(45) Date of publication and mention
of the grant of the patent:
**16.06.2004 Bulletin 2004/25**

(51) Int Cl.7: **H03F 1/32**, H03F 1/56

(21) Application number: **98119416.0**

(22) Date of filing: **14.10.1998**

(54) **Improved differential amplifier constituted of bipolar transistors**

Verbesserter Differenzverstärker mit Bipolartransistoren

Amplificateur différentiel amélioré à transistors bipolaires

(84) Designated Contracting States:
**DE FR GB**

(30) Priority: **14.10.1997 JP 28071597**

(43) Date of publication of application:
**21.04.1999 Bulletin 1999/16**

(73) Proprietor: **NEC Electronics Corporation
Kawasaki, Kanagawa 211-8668 (JP)**

(72) Inventor: **Sugawara, Michinori,
c/o NEC Corporation
Tokyo (JP)**

(74) Representative: **Betten & Resch
Postfach 10 02 51
80076 München (DE)**

(56) References cited:
**EP-A- 0 603 942        EP-A- 0 637 128
US-A- 4 855 684**

**Description**

Background of the Invention

Field of the invention

The present invention relates to a differential amplifier, and more specifically to a differential amplifier constituted of bipolar transistors.

Description of related art

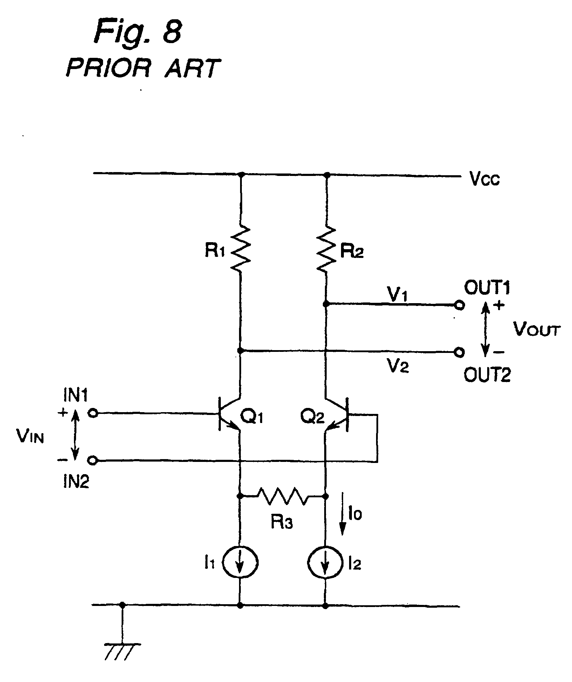

Referring to Fig. 8, there is shown a circuit diagram illustrating one example of a prior art differential amplifier constituted of bipolar transistors. In brief, the shown differential amplifier includes a pair of NPN bipolar transistors $Q_1$ and $Q_2$ having bases connected to a pair of input terminals IN1 and IN2, respectively, between which a differential input voltage $V_{IN}$ is applied. Collectors of the transistors $Q_1$ and $Q_2$ are connected to a power supply voltage $V_{CC}$ through load resistors $R_1$ and $R_2$, respectively. In addition, the collectors of the transistors $Q_1$ and $Q_2$ are connected to a pair of output terminals OUT1 and OUT2, respectively, from which a differential output voltage $V_{OUT}$ is obtained. Emitters of the transistors $Q_1$ and $Q_2$ are connected to ground through current sources $I_1$ and $I_2$ having a constant current $I_0$, respectively. The emitters of the transistors $Q_1$ and $Q_2$ are connected to each other through an emitter feedback resistor $R_3$.

The differential amplifier as shown in Fig. 8, constituted of bipolar transistors and including the emitter feedback resistor, is used as a differential amplifier having a relatively wide input voltage range which can be approximately deemed to operate linearly. In addition, the shown differential amplifier also has another advantage that a gain precision can be easily obtained since a nominal gain is given by a ratio between the emitter feedback resistor and the load resistors.

However, when the differential amplifier as shown in Fig. 8 is used as an input buffer in an analog-to-digital converter, since a high linearity is required, it is an ordinary practice to make improvement in order to elevate the linearity.

Now, assuming $R_1=R_2=1000\Omega$, $R_3=2000\Omega$ and $I_0=0.25$mA in the differential amplifier as shown in Fig. 8, the result of a "SPICE" (Simulation Program with Integrated Circuit Emphasis) simulation will be described in the following:

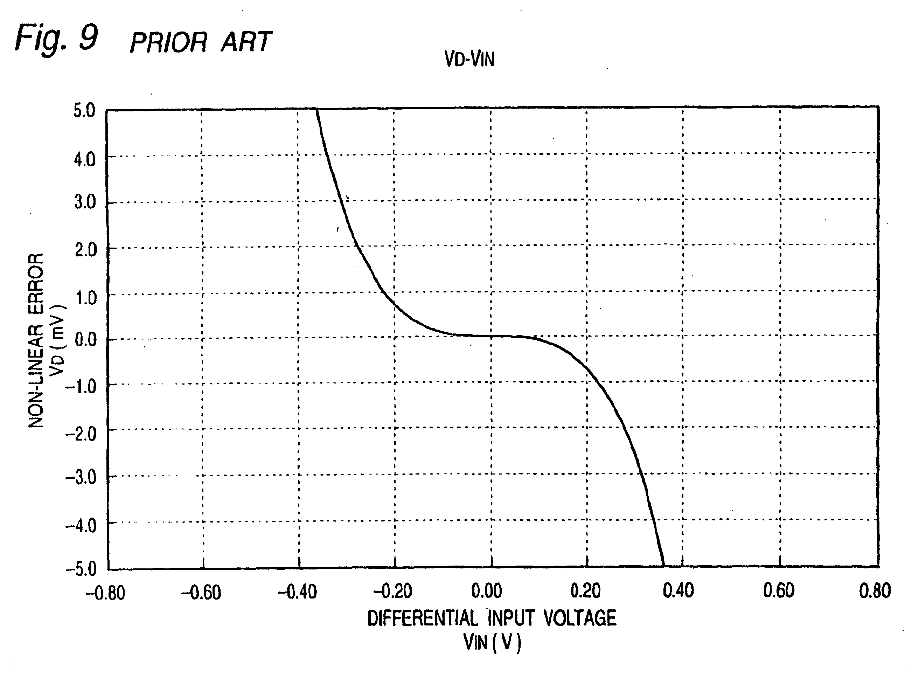

Fig. 9 is a graph illustrating a relation between a differential input voltage $V_{IN}$ and a non-linear error $V_D$ in the differential amplifier as shown in Fig. 8. Here, $V_D$ is a difference between a differential output voltage $V_{OUT}=V_{OUT}(V_{IN})$ and a tangential line $V_L = V_L(V_{IN})$ in differential output voltage $V_{OUT}(V_{IN})$ at the time of $V_{IN} = 0$V.

$$V_D = V_{OUT}(V_{IN}) - V_L(V_{IN})$$

Accordingly, $V_D$ is indicative of the non-linearity in the differential output voltage $V_{OUT}$. In the following, for purposes of convenience, this VD will be called a non-linear error.

If the differential output voltage $V_{OUT}$ has a complete linearity in relation to the differential input voltage $V_{IN}$, the non-linear error $V_D$ ceaselessly becomes zero.

For purposes of convenience, assume that if the non-linear error $V_D$ is within the range of $\pm 1$mV, it can be deemed to be linear. In this case shown in Fig. 9, the range of the differential input voltage $V_{IN}$ permitting the linear operation becomes $\pm 220$mV. On the other hand, since the differential output voltage $V_{OUT}$ of the shown differential amplifier is cramped at $\pm 500$mV, and since the nominal gain is 1 $(=2 \times R_1/R_3)$, a maximum operable range of the differential input voltage $V_{IN}$ is also $\pm 500$mV. However, the shown differential amplifier can operate in a linear operating mode in only a range which is a half of the

maximum operable range In addition, the gain at the differential input voltage $V_{IN} = 0$V, namely, the inclination of the tangential line $V_L$, is 0.86, which is smaller than the nominal gain 1 at some degree.

The non-linear operation of the differential amplifier shown in Fig. 8 is mainly attributable to the circumstances that a base-emitter voltage ($V_{BE}$) of the bipolar transistors $Q_1$ and $Q_2$ non-linearly changes in relation to a collector current ($I_C$).

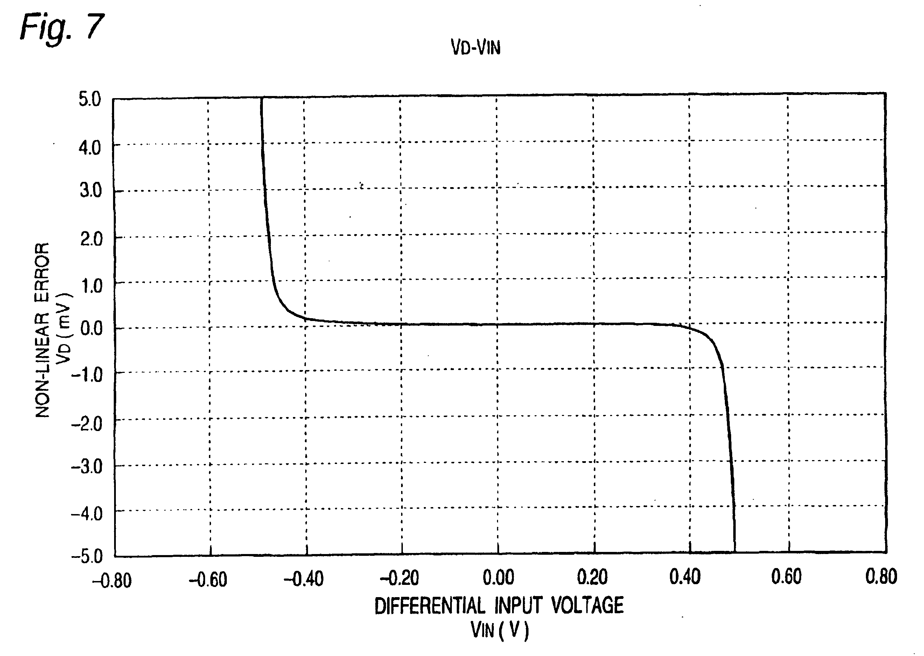

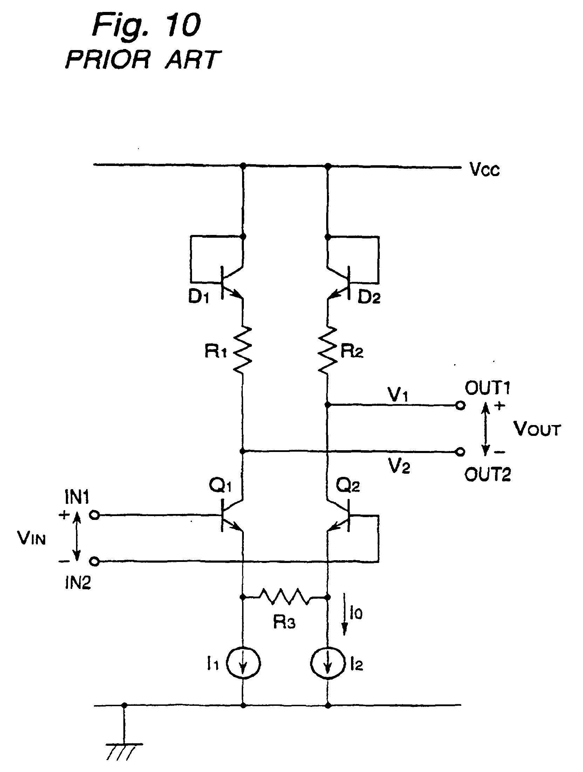

Now, one prior art example for improving the linearity will be described with reference to Fig. 10, which is a circuit diagram illustrating another prior art example of the differential amplifier, which is constituted to improve the linearity of the differential amplifier shown in Fig. 8 and which is shown in Fig. 7(a) of T. Kumamoto et at, "A 10-bit 50MS/s 500mW A/D Converter with Differential-Voltage Subconverter", Technical Report of IEICE (The Institute of Electronics, Information and Communication Engineers (in Japan)), ED93-47, ICD93-46 (1994-06), pp17-22. In Fig. 10, elements corresponding to those shown in Fig. 8 are given the same Reference Numerals, and explanation will be omitted.

In the differential amplifier shown in Fig. 10, diodes $D_1$ and $D_2$ are inserted between the power supply voltage $V_{CC}$ and the load resistors $R_1$ and $R_2$, respectively. In this example, the non-linearity is compensated by the diodes $D_1$ and $D_2$, so that a linear differential output voltage is obtained.

Actually, assuming $R_1 = R_2 = R_3/2$, the differential output voltage $V_{OUT}$ is expressed as follows:

$$V_{OUT} = (2 \times R_1 / R_3) \times (V_{IN} - V_{BE1} + V_{BE2}) + V_{D1} - V_{D2}$$

$$= V_{IN} - V_{BE1} + V_{BE2} + V_{D1} - V_{D2}$$

$$= V_{IN}$$

where $V_{BE1}$, $V_{BE2}$, $V_{D1}$ and $V_{D2}$ are a base-emitter voltage of the bipolar transistors $Q_1$ and $Q_2$, and a forward-direction voltage drop of the diodes $D_1$ and $D_2$, respectively. In addition, $V_{BE1}$ is substantially equal to $V_{D1}$ (since a current flowing through $Q_1$ is substantially equal to a current flowing through $D_1$), and also $V_{BE2}$ is substantially equal to $V_{D2}$. Thus, the result expressed by the above equation is obtained.

Now, assuming $R_1 = R_2 = 1000\Omega$, $R_3 = 2000\Omega$ and $I_0 = 0.25mA$ in the differential amplifier as shown in Fig. 10, the result of the SPICE simulation will be described in the following:

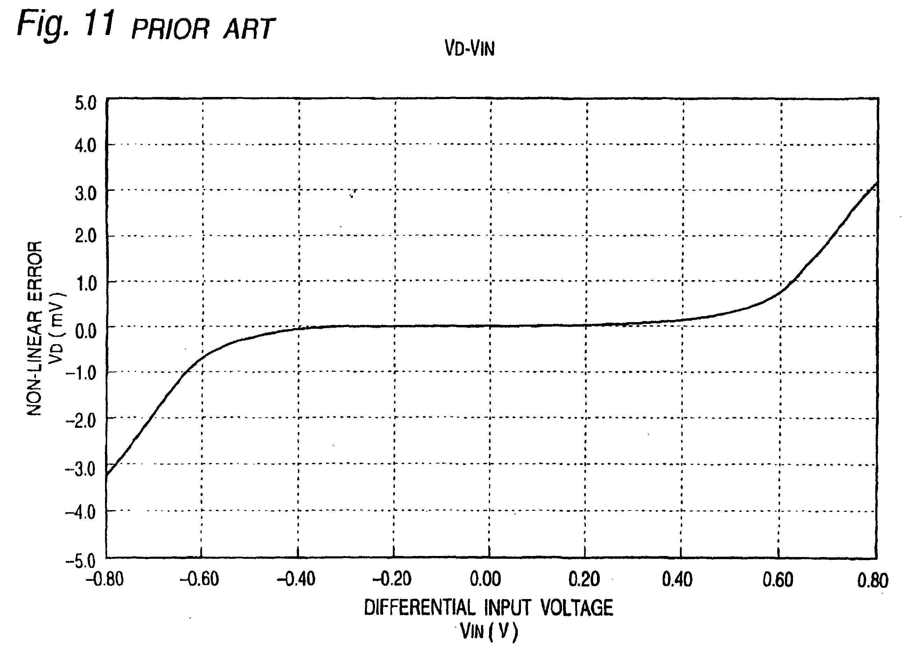

Fig. 11 is a graph illustrating a relation between a differential input voltage $V_{IN}$ and a non-linear error $V_D$ in the differential amplifier as shown in Fig. 10. As seen from comparison between Fig. 9 and Fig. 11, the differential amplifier shown in Fig. 10 has a linearly operating range wider than that of the differential amplifier shown in Fig. 8. Namely, the differential amplifier shown in Fig. 10 has an improved linearity.

In addition, the gain at the differential input voltage $V_{IN} = 0V$, namely, the inclination of the tangential line $V_L$, is 0.9808. which is slightly than the nominal gain 1 but is nearer to 1, in comparison with the differential amplifier shown in Fig. 8.

However, since the differential amplifier shown in Fig. 10 includes the diode connected in series with the load resistor, a common-mode output potential drops by the forward-direction voltage drop (about 0.8V) of the diode, and therefore, when the power supply voltage is low, a next-stage circuit directly receiving the output of the differential amplifier becomes difficult to properly operate at a low power supply voltage.

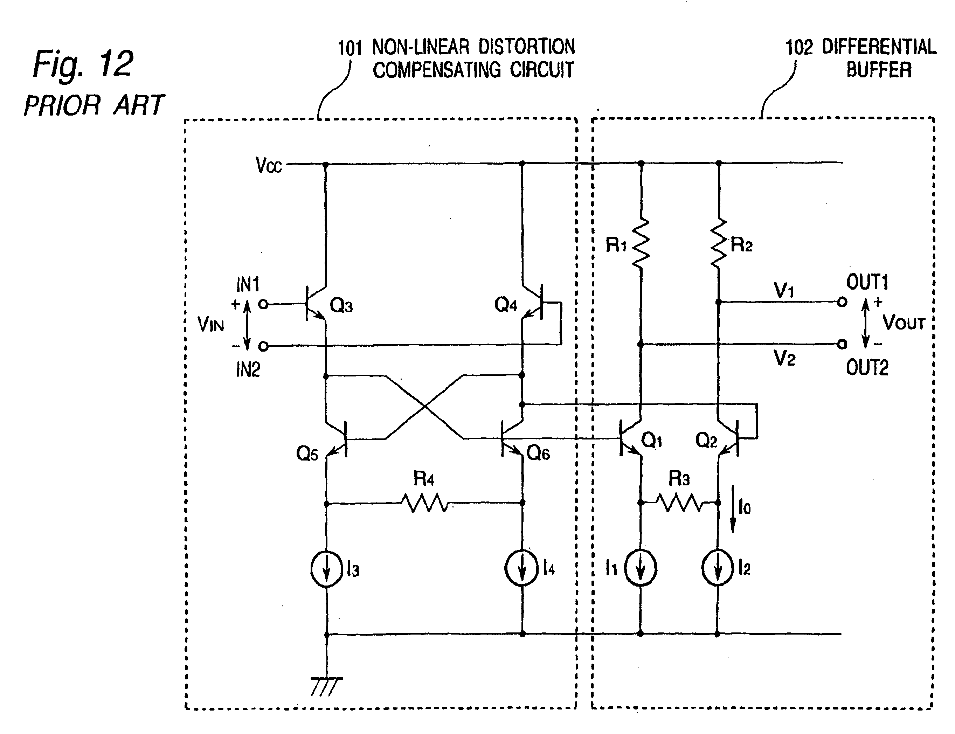

Referring to Fig. 12, there is shown a circuit diagram illustrating still another prior art example of the differential amplifier, which is shown in Japanese Patent Application Pre-examination Publication No. JP-A-57-160207, which corresponds to U.S. Patent 4,496,860. Also in EP 0 637 128 such a circuit is disclosed. In Fig. 12, elements corresponding to those shown in Fig. 8 are given the same Reference Numerals, and explanation will be omitted.

The differential amplifier shown in Fig. 12 includes a non-linear distortion compensating circuit 101 provided as an input stage receiving a differential input voltage, and a differential buffer 102 constructed completely similarly to the differential amplifier shown in Fig. 8. The non-linear distortion compensating circuit 101 includes a pair of NPN bipolar transistors $Q_3$ and $Q_4$ having collectors connected directly to a power supply voltage $V_{CC}$. Bases of the transistors $Q_3$ and $Q_4$ are connected to a pair of input terminals IN1 and IN2, respectively, between which a differential input voltage $V_{IN}$ is applied. Emitters of the transistors $Q_3$ and $Q_4$ are connected to the bases of the transistors $Q_1$ and $Q_2$, respectively.

The non-linear distortion compensating circuit 101 also includes another pair of NPN bipolar transistors $Q_5$ and $Q_6$ each having a base cross-connected to a collector of the other of the pair of NPN bipolar transistors $Q_5$ and $Q_6$. The collectors of the NPN bipolar transistors $Q_5$ and $Q_6$ are connected to the emitters of the transistors $Q_3$ and $Q_4$, respectively. Emitters of the transistors $Q_5$ and $Q_6$ are connected to ground through current sources $I_3$ and $I_4$, respectively. The emitters of the transistors $Q_5$ and $Q_6$ are connected to each other through an emitter feedback resistor $R_4$.

In the differential amplifier shown in Fig. 12, a current of an emitter follower (the bipolar transistors $Q_3$ and $Q_4$) in the non-linear distortion compensating circuit 101 changes dependently upon the input differential voltage $V_{IN}$ (input signal), and a base-emitter voltage $V_{BE}$ of the bipolar transistors $Q_3$ and $Q_4$ changes dependently upon the change of the current of the emitter follower, with the result that the change of the base-emitter voltage $V_{BE}$ of the bipolar transistors $Q_1$ and $Q_2$ in the differential buffer 102 is canceled, so that a linear differential output voltage can be obtained.

Actually, assuming $R_1 = R_2 = R_3/2 = R_4/2$, the differential output voltage $V_{OUT}$ of the differential amplifier shown in Fig. 12 is expressed as follows:

$$V_{OUT} = (2 \times R_1 / R_3) \times (V_{IN} - V_{BE3} - V_{BE1} + V_{BE4} + V_{BE2})$$

$$= V_{IN} - V_{BE3} - V_{BE1} + V_{BE4} + V_{BE2}$$

$$= V_{IN}$$

where $V_{BE1}$, $V_{BE2}$, $V_{BE3}$ and $V_{BE4}$ are a base-emitter voltage of the bipolar transistors $Q_1$, $Q_2$, $Q_3$ and $Q_4$, respectively. In addition. $V_{BE1}$ is substantially equal to $V_{BE4}$ (since a current flowing through $Q_1$ is substantially equal to a current flowing through $Q_4$), and also $V_{BE2}$ is substantially equal to $V_{BE3}$. Thus, the result expressed by the above equation is obtained.

Differently from the differential amplifier shown in Fig. 10, since the differential amplifier shown in Fig. 12 has no drop in the common-mode output voltage, a next-stage circuit directly receiving the output of the differential amplifier becomes can properly operate at a low power supply voltage. In addition, the nominal gain is not necessarily required to be 1.

For reference, the gain at the differential input voltage $V_{IN}$ = 0V, namely, the inclination of the tangential line $V_L$, is 0.9718, which is slightly than the nominal gain 1.

Actually, however, because of a base current of the bipolar transistors $Q_1$, $Q_2$, $Q_3$ and $Q_4$ which was ignored in the above mentioned equation, improvement of the linearity is not so good, and therefore, it has a disadvantage that the linearly operating range is narrow.

Now, assuming $R_1 = R_2 = 1000\Omega$, $R_3 = 2000\Omega$ and $I_0 = 0.25$mA in the differential amplifier as shown in Fig. 12, the result of the SPICE simulation will be described in the following:

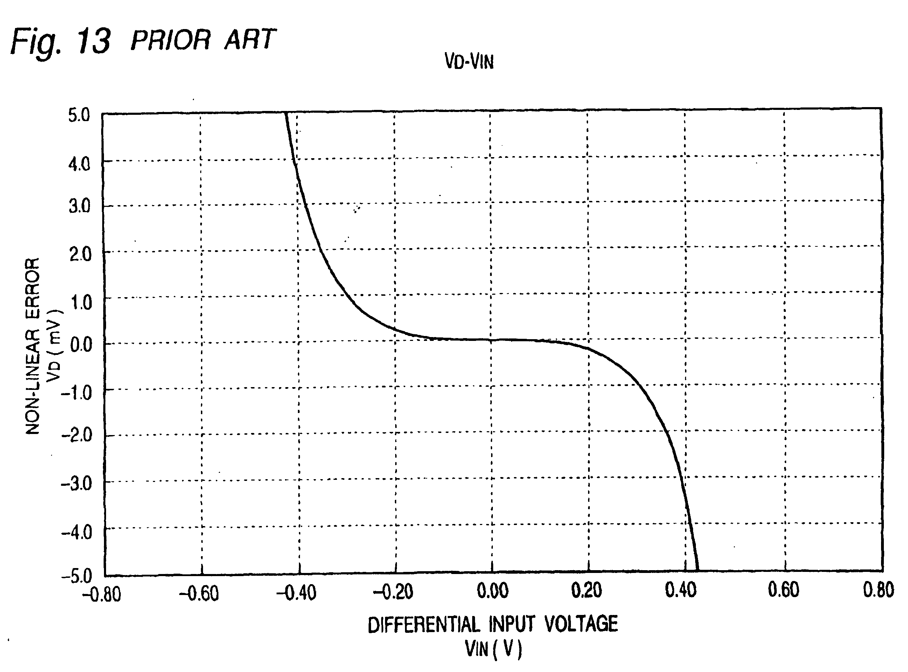

Fig. 13 is a graph illustrating a relation between a differential input voltage $V_{IN}$ and a non-linear error $V_D$ in the differential amplifier as shown in Fig. 12. As shown in Fig. 13, the linearly operating range is about ±300mV, which cannot be said to be sufficiently wide.

Next, influence of the base current will be described.

$V_{BE1}$ and $V_{BE4}$ in this prior art differential amplifier shown in Fig. 12 are given by the following equations:

$$V_{BE1} = V_T \times \ln(I_{C1} / I_S)$$

$$V_{BE4} = V_T \times \ln[\{(\beta / (\beta+1)\} \times (I_{C6} + I_{B2} + I_{B5}) / I_S]$$

$$= V_T \times \ln[\{(\beta / (\beta+1)\} \times (I_{C1} + (2/\beta) \times I_{C2}\} / I_S]$$

where $V_T$ is a thermal voltage ($V_T$ = kT/q; k = Boltzmann constant, T = absolute temperature, q = elementary charge), $I_S$ is a saturation current, $I_{C1}$ to $I_{C6}$ and $I_{B1}$ to $I_{B6}$ are a collector current and a base current of the transistors $Q_1$ to $Q_6$, and $\beta$ is a current gain. IN addition, since the differential amplifier shown in Fig. 12 has a current mirror structure, a relation of $I_{C6} = I_{C1}$ and $I_{B2} = I_{B5}$ holds. By using this relation, the equation was modified.

The currents $I_{C1}$ to $I_{C6}$ change upon the change of the differential input voltage $V_{IN}$, but if the change of $V_{BE1}$ is equal to the change of $V_{BE4}$, the linear operation of the circuit is obtained. Actually, however, since the base currents exist, it would be understood from the above equation that the change of $V_{BE1}$ never becomes equal to the change of $V_{BE4}$.

Summary of the Invention

Accordingly, it is an object of the present invention to provide a differential amplifier which has overcome the above mentioned defects of the conventional ones.

Another object of the present invention is to provide a differential amplifier having a widened linearly operating range and having a high common-phase output potential to permit a next-stage circuit to operate at a low power supply voltage.

The above and other objects of the present invention are achieved in accordance with the present invention by a differential amplifier as defined in claim 1. Further embodiments of the invention are claimed in the dependent claims.

The above and other objects, features and advantages of the present invention will be apparent from the following description of preferred embodiments of the invention with reference to the accompanying drawings.

Brief Description of the Drawings

Fig. 1 is a circuit diagram illustrating a basic construction of the differential amplifier in accordance with the present invention;
Fig. 2 is a circuit diagram of a first embodiment of the differential amplifier shown in Fig. 1;
Fig. 3 is a graph illustrating a relation between a differential input voltage $V_{IN}$ and a non-linear error $V_D$ in the differential amplifier shown in Fig. 2, based on the SPICE simulation;
Fig. 4 is a circuit diagram of a second embodiment of the differential amplifier shown in Fig. 1;
Fig. 5 is a graph illustrating a relation between a differential input voltage $V_{IN}$ and a non-linear error $V_D$ in the differential amplifier shown in Fig. 4, based on the SPICE simulation;
Fig. 6 is a circuit diagram of a third embodiment of the differential amplifier shown in Fig. 1;
Fig. 7 is a graph illustrating a relation between a differential input voltage $V_{IN}$ and a non-linear error $V_D$ in the differential amplifier shown in Fig. 6, based on the SPICE simulation;
Fig. 8 is a circuit diagram illustrating one example of the prior art differential amplifier constituted of bipolar transistors;
Fig. 9 is a graph illustrating a relation between a differential input voltage $V_{IN}$ and a non-linear error $V_D$ in the differential amplifier shown in Fig. 8, based on the SPICE simulation;
Fig. 10 is a circuit diagram illustrating another example of the prior art differential amplifier constituted of bipolar transistors;
Fig. 11 is a graph illustrating a relation between a differential input voltage $V_{IN}$ and a non-linear error $V_D$ in the differential amplifier shown in Fig. 10, based on the SPICE simulation;
Fig. 12 is a circuit diagram illustrating still another example of the prior art differential amplifier constituted of bipolar transistors; and
Fig. 13 is a graph illustrating a relation between a differential input voltage $V_{IN}$ and a non-linear error $V_D$ in the differential amplifier shown in Fig. 12, based on the SPICE simulation.

Description of the Preferred embodiments

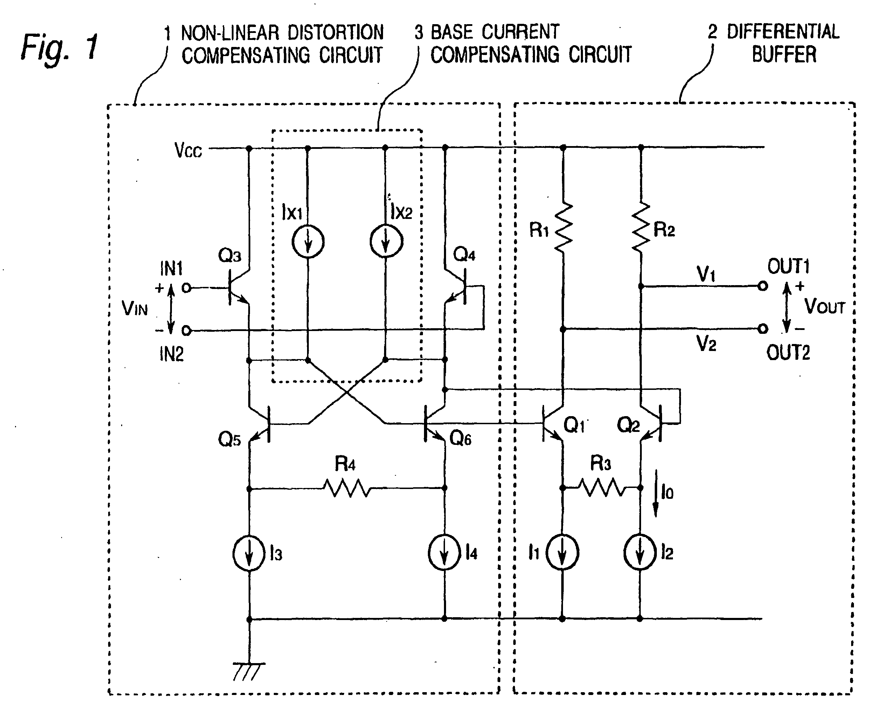

Now, embodiments of the differential amplifier in accordance with the present invention will be described with reference to the accompanying drawings.
Referring to Fig. 1, there is shown a circuit diagram illustrating a basic construction of the differential amplifier in accordance with the present invention. In Fig. 1, elements corresponding to those shown in Fig. 12 are given the same Reference Numerals.
The differential amplifier shown in Fig. 1 includes a non-linear distortion compensating circuit 1 including a differential emitter follower and a first group of current sources having a first differential pair of transistors having bases receiving a pair of emitter currents of the differential emitter follower, respectively, so that the first group of current sources are controlled by the pair of emitter currents of the differential emitter follower, and a differential buffer 2 including a second differential pair of transistors having bases receiving signals outputted from the non-linear distortion compensating circuit 1, respectively. Furthermore, the non-linear distortion compensating circuit 1 includes a base current compensating circuit 3 for supplying at least a portion of each of base currents of the transistors of the second differential pair in the differential buffer 2 and the transistors of the first differential pair in the first group of current sources.
More specifically, the non-linear distortion compensating circuit 1 includes a differential pair of NPN bipolar transistors $Q_3$ and $Q_4$ having collectors connected directly to a power supply voltage of a predetermined potential ($V_{CC}$). Bases of the transistors $Q_3$ and $Q_4$ are connected to a pair of input terminals IN1 and IN2, respectively, between which a differential input voltage $V_{IN}$ is applied. The non-linear distortion compensating circuit 101 also includes an NPN bipolar transistor $Q_5$ having a collector connected to an emitter of the transistor $Q_3$ and a base connected to an emitter of the transistor $Q_4$, and an NPN bipolar transistor $Q_6$ having a collector connected to an emitter of the transistor $Q_4$ and a base connected to an emitter of the transistor $Q_3$, a resistor $R_4$ connected between an emitter of the NPN bipolar transistor $Q_5$ and an emitter of the NPN bipolar transistor $Q_6$, a constant current source $I_3$ connected between the emitter of the NPN bipolar transistor $Q_5$ and the ground, a constant current source $I_4$. connected between the emitter of the NPN bipolar transistor $Q_6$ and the ground, a current source $I_{X1}$ connected between the emitter of the NPN bipolar transistor $Q_3$ and the power supply voltage $V_{CC}$, and a current source $I_{X2}$ connected between the emitter of the NPN bipolar transistor $Q_4$ and the power supply voltage $V_{CC}$. The differential emitter follower is constituted of the transistors $Q_3$ and $Q_4$. The first group of current sources are constituted of the transistors $Q_5$ and $Q_6$ and the constant current sources $I_3$ and $I_4$. The base current compensating circuit 3 is constituted of the current sources $I_{X1}$

and $I_{X2}$.

On the other hand, the differential buffer 2 includes a differential pair of NPN transistors $Q_1$ and $Q_2$ having bases connected to receive emitter potentials of the transistors $Q_3$ an $Q_4$, respectively, a pair of resistors $R_1$ and $R_2$ connected between collectors of the NPN transistors $Q_1$ and $Q_2$ and the power supply voltage $V_{CC}$, respectively, a resistor $R_3$ connected between an emitter of the transistor $Q_1$ and an emitter of the transistor $Q_2$, a constant current source $I_1$ connected between an emitter of the transistor $Q_1$ and the ground, and a constant current source $I_2$ connected between an emitter of the transistor $Q_2$. Thus, the collectors of the transistors $Q_1$ and $Q_2$ are supplied through the resistors $R_1$ and $R_2$ with a predetermined potential ($V_{CC}$).

Next, an operation of the differential amplifier constructed as mentioned above will be described.

In brief, a differential input voltage $V_{IN}$ applied between the bases of the transistors $Q_3$ and $Q_4$ is supplied between the bases of the transistors $Q_1$ and $Q_2$ while the potential difference is maintained as it is, and then, is multiplied by the nominal gain of $\{(R_1+R_2)/R_3\}$ so that it is outputted between the collectors of the transistors $Q_1$ and $Q_2$ as the differential output voltage $V_{OUT}$.

Next, a linearity of the differential output voltage $V_{OUT}$ to the differential input voltage $V_{IN}$ will be described.

As mentioned hereinbefore, since

$$V_{OUT} = \{(R_1 + R_2) / R_3\} \times (V_{IN} - V_{BE3} - V_{BE1} + V_{BE4} + V_{BE2})$$

the following equation holds as regards a change amount:

$$\Delta V_{OUT} = A \times (\Delta V_{IN} - \Delta V_{BE3} - \Delta V_{BE1} + \Delta V_{BE4} + \Delta V_{BE2})$$

where $A = (R_1 + R_2) / R_3$, and $\Delta V_{OUT}$, $\Delta V_{IN}$, $\Delta V_{BE3}$, $\Delta V_{BE1}$, $\Delta V_{BE4}$ and $\Delta V_{BE2}$ are a change amount of $V_{OUT}$, $V_{IN}$, $V_{BE3}$, $V_{BE1}$, $V_{BE4}$ and $V_{BE2}$, respectively.

Accordingly, in order to establish the linearity, it is sufficient if a relation of $\Delta V_{BE1} = \Delta V_{BE4}$ and $\Delta V_{BE2} = \Delta V_{BE3}$ holds.

Since

$$\Delta V_{BE4} = V_T \times \ln \{I_{C1} + \Delta I_C + (2/\beta) \times (I_{C2} - \Delta I_C) - I_X - \Delta I_X\}$$

$$- V_T \times \ln \{I_{C1} + (2/\beta) \times I_{C2} - I_X\}$$

and

$$\Delta V_{BE1} = V_T \times \ln (I_{C1} + \Delta I_C) - V_T \times \ln I_{C1}$$

a linear operation is realized by giving $I_X$ which makes $V_{BE4}$ equal to $V_{BE1}$. Here, it is assumed that $\Delta I_C = \Delta I_{C1} = -\Delta I_{C2}$. Since a similar relation holds in connection with $\Delta V_{BE2}$ and $\Delta V_{BE3}$, explanation will be omitted.

Embodiment 1

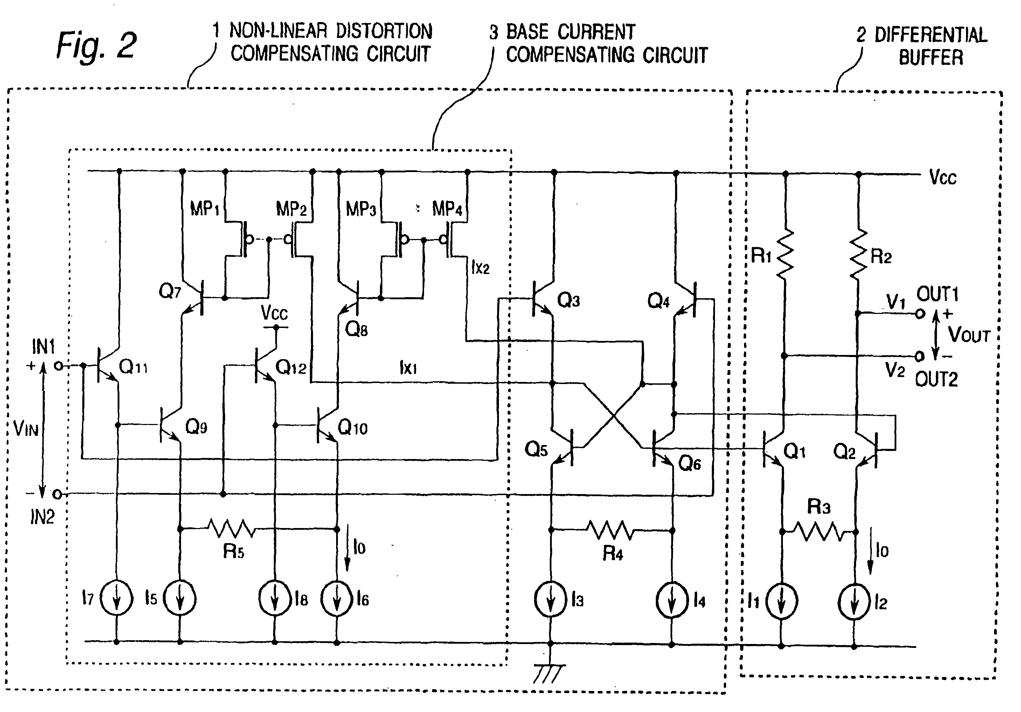

Referring to Fig. 2, there is shown a circuit diagram of a first embodiment of the differential amplifier shown in Fig. 1. In Fig. 2, elements corresponding to those shown in Fig. 1 are given the same Reference Numerals, and explanation will be omitted for simplification of description.

In order to make the current sources $I_{X1}$ and $I_{X2}$ shown in Fig. 1 equal to a sum of base currents of the transistors $Q_1$ and $Q_6$ and a sum of base currents of the transistors $Q_2$ and $Q_5$, respectively, the base current compensating circuit 3 in this first embodiment includes, as shown in Fig. 2, PMOS transistors $MP_1$ to $MP_4$ controlled by base currents of transistors $Q_7$ and $Q_8$, a current control circuit composed of transistors $Q_9$ and $Q_{10}$ and a resistor $R_5$ for supplying currents to the transistors $Q_7$ and $Q_8$, and emitter follower transistors $Q_{11}$ and $Q_{12}$ receiving the differential input voltage, for controlling the current control circuit composed of the transistors $Q_9$ and $Q_{10}$ and the resistor $R_5$.

Specifically, the input terminal IN1 is connected to a base of the transistor $Q_{11}$, and the input terminal IN2 is connected to a base of the transistor $Q_{12}$. Collectors of the transistors $Q_{11}$ and $Q_{12}$ are connected to the power supply voltage $V_{CC}$. An emitter of the transistor $Q_{11}$ is connected to a base of the transistor $Q_9$ and also connected to the ground through a constant current source $I_7$. An emitter of the transistor $Q_{12}$ is connected to a base of the transistor

$Q_{10}$ and also connected through a constant current source $I_8$ to the ground.

A collector of the transistor $Q_9$ is connected to an emitter of the transistor $Q_7$, and an emitter of the transistor $Q_9$ is connected through a constant current source $I_5$ to the ground. A collector of the transistor $Q_{10}$ is connected to an emitter of the transistor $Q_8$, and an emitter of the transistor $Q_{10}$ is connected through a constant current source $I_6$ to the ground, and also connected through the resistor $R_5$ to the emitter of the transistor $Q_9$.

Collectors of the transistors $Q_7$ and $Q_8$ are connected to the power supply voltage $V_{CC}$. A base of the transistor $Q_7$ is connected to a drain and a gate of the PMOS transistor $MP_1$ and a gate of the PMOS transistor $MP_2$. Sources of the PMOS transistors $MP_1$ and $MP_2$ are connected to the power supply voltage $V_{CC}$. A drain of the PMOS transistor $MP_2$ is connected to the bases of the transistors $Q_1$ and $Q_6$. Therefore, the PMOS transistors $MP_1$ and $MP_2$ constitute a current mirror circuit.

A base of the transistor $Q_8$ is connected to a drain and a gate of the PMOS transistor $MP_3$ and a gate of the PMOS transistor $MP_4$. Sources of the PMOS transistors $MP_3$ and $MP_4$ are connected to the power supply voltage $V_{CC}$. A drain of the PMOS transistor $MP_4$ is connected to the bases of the transistors $Q_2$ and $Q_5$. Therefore, the PMOS transistors $MP_3$ and $MP_4$ constitute a current mirror circuit.

Here, all the constant current sources $I_1$ to $I_8$ have the same current value $I_0$. For example, $I_0 = 0{,}25mA$, $R_1=R_2=1k\Omega$, and $R_3=R_4=R_5=2k\Omega$.

Now, an operation of the differential amplifier constructed as mentioned above will be described.

Since the base current of the transistor $Q_8$ is substantially equal to the base current of the transistor $Q_2$, if the current mirror circuit formed of the PMOS transistors $MP_3$ and $MP_4$ is so designed that a current equal to a double of the current flowing through the PMOS transistor $MP_3$, flows through the PMOS transistor $MP_4$ (magnifying power of 2), the PMOS transistor $MP_4$ can supply the base currents of the transistors $Q_2$ and $Q_5$, so that the current flowing through the transistor $Q_4$ is no longer required to supply the base currents of the transistors $Q_2$ and $Q_5$. Accordingly, $\Delta V_{BE4}$ is expressed by the following equation:

$$\Delta V_{BE4} = V_T \times \ln \{I_{C1} + \Delta I_C + (2/\beta) \times (I_{C2} - \Delta I_C) - I_X - \Delta I_X)$$

$$- V_T \times \ln \{I_{C1} + (2/\beta) \times I_{C2} - I_X\}$$

$$= V_T \times \ln (I_{C1} + \Delta I_C) - V_T \times \ln I_{C1}$$

$$= \Delta V_{BE1}$$

Similarly, it becomes $\Delta V_{BE3} = \Delta V_{BE2}$. Thus, a linear operation is realized.

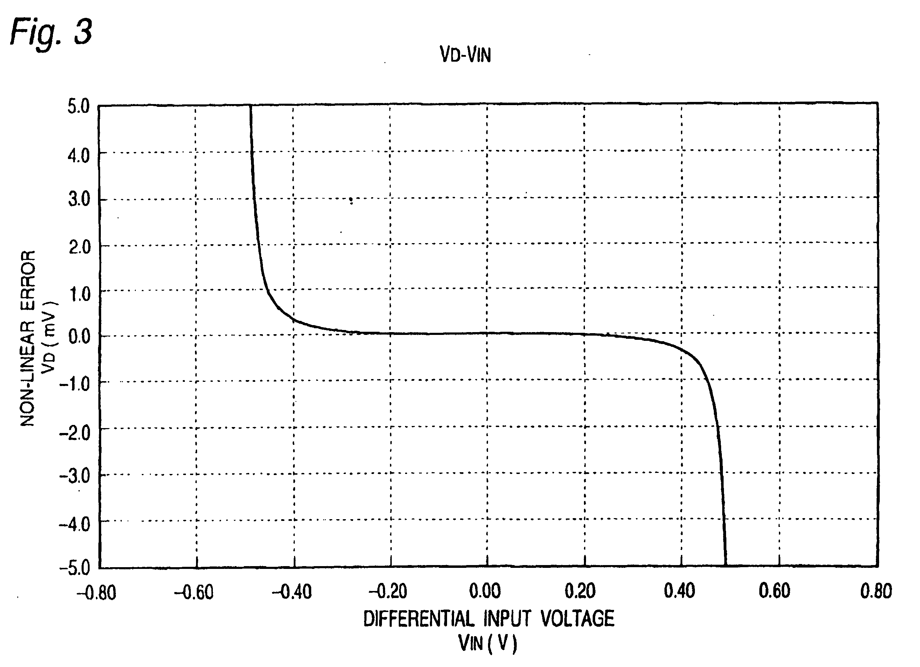

Referring to Fig. 3, there is shown a graph illustrating a relation between a differential input voltage $V_{IN}$ and a non-linear error $V_D$ in the differential amplifier shown in Fig. 2, based on the SPICE simulation.

As shown in Fig. 3, the linearly operating range was extended to $\pm 450mV$. In addition, the gain was 0.9789, which is larger than that obtained in the prior art differential amplifier shown in Fig. 12.

Incidentally, if the current value of the constant current sources $I_5$ and $I_6$ is halved (to $I_0/2$), and furthermore, if the PMOS transistor current mirror circuits are so designed that the output current is four times the input current (magnifying power of 4), a similar effect can be obtained.

In addition, if the current value of the constant current sources $I_3$ and $I_4$ are made to $I_0/k$, and also if the resistance of the resistor $R_4$ is made to k times, and if the magnifying power of the PMOS transistor current mirror circuits is suitably set so as to supply necessary base currents, a similar effect can be obtained. Furthermore, the current value of the constant current sources $I_7$ and $I_8$ can be changed from $I_0$. In this case, it is sufficient if the size ratio of the bipolar transistors is suitably changed if necessary.

Moreover, it would be apparent that the transistors $Q_{11}$ and Q12 of the emitter follower can be constructed similarly to the non-linear distortion compensating circuit shown in Fig. 12, so as to realize the matching of the base currents.

Since modifications in the size of the constituents and in the ratio of the currents are a matter of design to persons skilled in the art, a further explanation will be omitted.

In the above mentioned equation, the output resistance of the current sources $I_{X1}$ and $I_{X2}$ was deemed to be infinite. However, in this embodiment, the current sources $I_{X1}$ and $I_{X2}$ have a non-negligible finite output resistance. When the current gain $\beta$ is actually not the constant but varies upon the current value and the collector-emitter voltage, it is in some cases that a more excellent linearity can be obtained when the current sources $I_{X1}$ and $I_{X2}$ have a finite output resistance, than when the current sources $I_{X1}$ and $I_{X2}$ have an infinite output resistance. However, if it is desired to cause the current sources $I_{X1}$ and $I_{X2}$ to have a large output resistance enough to be deemed to be infinite, it is possible to use a well-known manner in which a drain of each of the PMOS transistors $MP_2$ and $MP_4$ is cascade-

connected with a PMOS transistor having a gate suitably biased, so that the output resistance of the current sources $I_{X1}$ and $I_{X2}$ is enlarged. This is true in embodiments which will be described hereinafter.

Embodiment 2

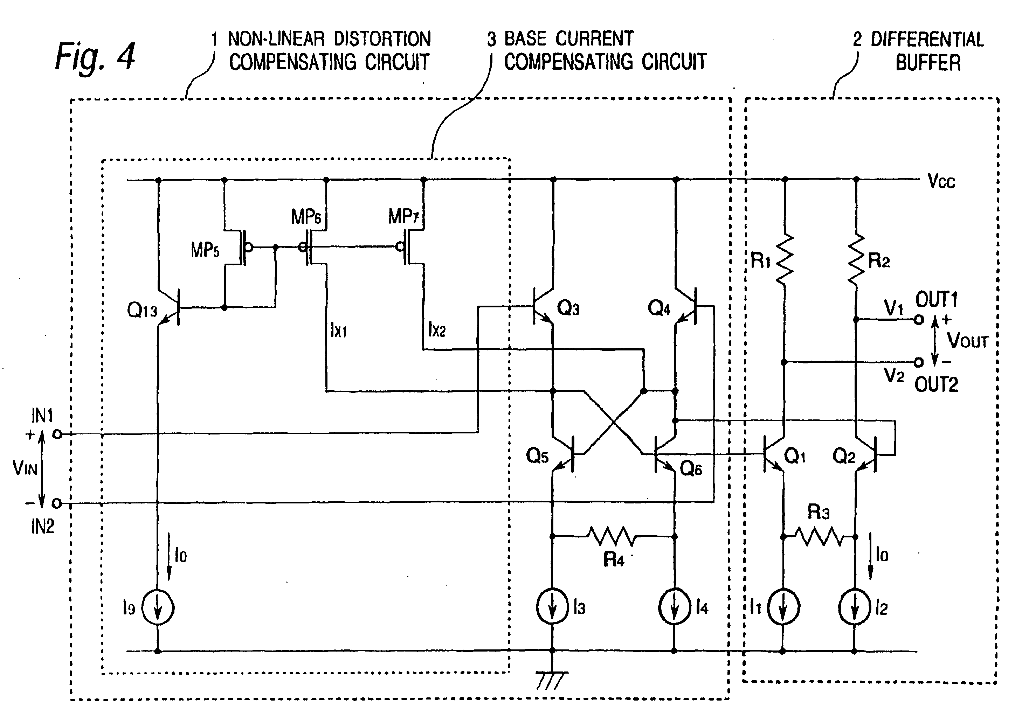

Referring to Fig. 4, there is shown a circuit diagram of a second embodiment of the differential amplifier shown in Fig. 1. In Fig. 4, elements corresponding to those shown in Fig. 1 are given the same Reference Numerals, and explanation will be omitted for simplification of description.

The base current compensating circuit 3 in this second embodiment, namely, the current sources $I_{X1}$ and $I_{X2}$ shown in Fig. 1, include an NPN transistor $Q_{13}$ having a collector connected to the power supply voltage $V_{CC}$ and an emitter connected through a constant current source $I_9$ to the ground, and a current mirror circuit composed of three PMOS transistors $MP_5$ to $MP_7$ having sources connected to the power supply voltage $V_{CC}$. A base of the NPN transistor $Q_{13}$ is connected to a gate and a drain of the PMOS transistor $MP_5$ and a gate of each of the PMOS transistors $MP_6$ and $MP_7$. A drain of the PMOS transistor $MP_6$ is connected to the bases of the transistors $Q_1$ and $Q_6$, and a drain of the PMOS transistor $MP_7$ is connected to the bases of the transistors $Q_2$ and $Q_5$.

Since a base current of the transistor $Q_{13}$ is substantially equal to the base current of the transistor $Q_2$ when the different input voltage $V_{IN}$ is 0 (zero), if the current mirror circuit of the PMOS transistors $MP_5$ to $MP_7$ is designed to have the magnifying power of 4 so that the current flowing through each of PMOS transistors $MP_6$ and $MP_7$ is equal to a double of the current flowing through PMOS transistor $MP_5$, it is possible to supply a constant amount portion of the base currents of the transistors $Q_2$ and $Q_5$ and a constant amount portion of the base currents of the transistors $Q_1$ and $Q_6$ from the base current compensating circuit 3 of the second embodiment. Accordingly, $\Delta V_{BE4}$ is expressed by the following equation:

$$\Delta V_{BE4} = V_T \times \ln \{I_{C1\_0} + \Delta I_C + (2/\beta) \times (I_{C2\_0} - \Delta I_C) - I_X - \Delta I_X$$

$$- V_T \times \ln \{I_{C1\_0} + (2/\beta) \times I_{C2\_0} - I_X\}$$

$$= V_T \times \ln \{I_{C1\_0} + \Delta I_C + (2/\beta) \times (I_{C2\_0} - \Delta I_C)\}$$

$$- V_T \times \ln \{I_{C1\_0} + (2/\beta) \times I_{C2\_0}\}$$

$$= V_T \times \ln (I_{C1\_0} + \Delta I_C) - V_T \times \ln I_{C1\_0}$$

$$= \Delta V_{BE1}$$

where $I_{C1\_0}$ is $I_{C1}$ when $V_{IN}$ is zero and $I_{C2\_0}$ is $I_{C2}$ when $V_{IN}$ is zero, and it is deemed to be $\Delta I_X=0$ under assumption that $I_X=(4/\beta) \times I_{C1\_0}$, $I_{C2\_0} = I_{C1\_0}$, and the output resistance is infinite.

Similarly, it becomes $\Delta V_{BE3} = \Delta V_{BE2}$. Thus, a linear operation is realized.

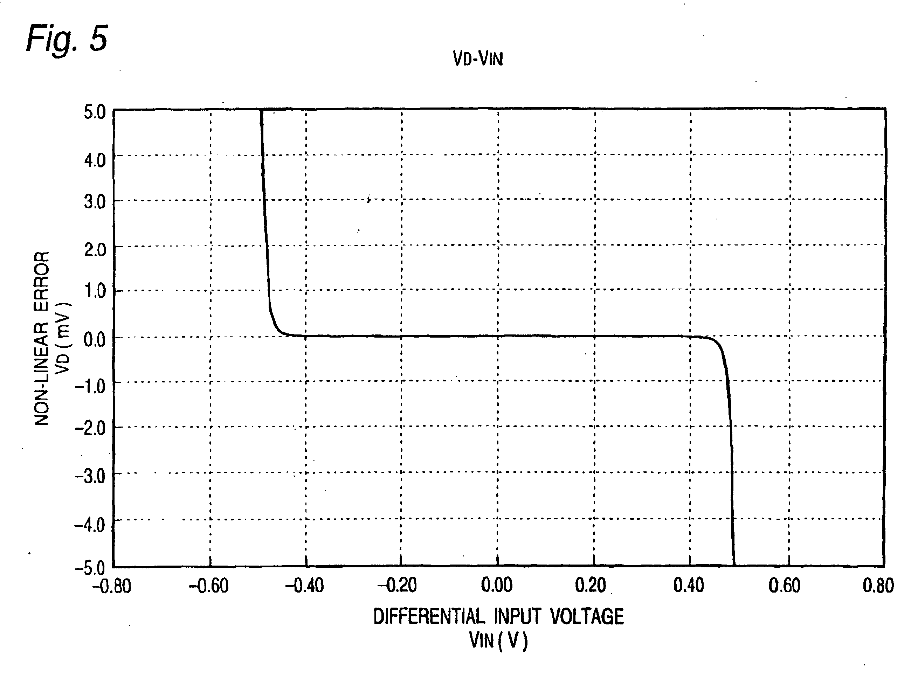

Referring to Fig. 5, there is shown a graph illustrating a relation between a differential input voltage $V_{IN}$ and a non-linear error $V_D$ in the differential amplifier shown in Fig. 4, based on the SPICE simulation.

As shown in Fig. 5, the linearly operating range was extended to $\pm480$mV. In addition, the gain was 0.9783, which is larger than that obtained in the prior art differential amplifier shown in Fig. 12.

In this second embodiment, the number of the constant current sources required to construct the current sources $I_{X1}$ and $I_{X2}$ is reduced to one from four required in the first embodiment. Therefore, the second embodiment can realize a low power consumption in comparison with the first embodiment.

Embodiment 3

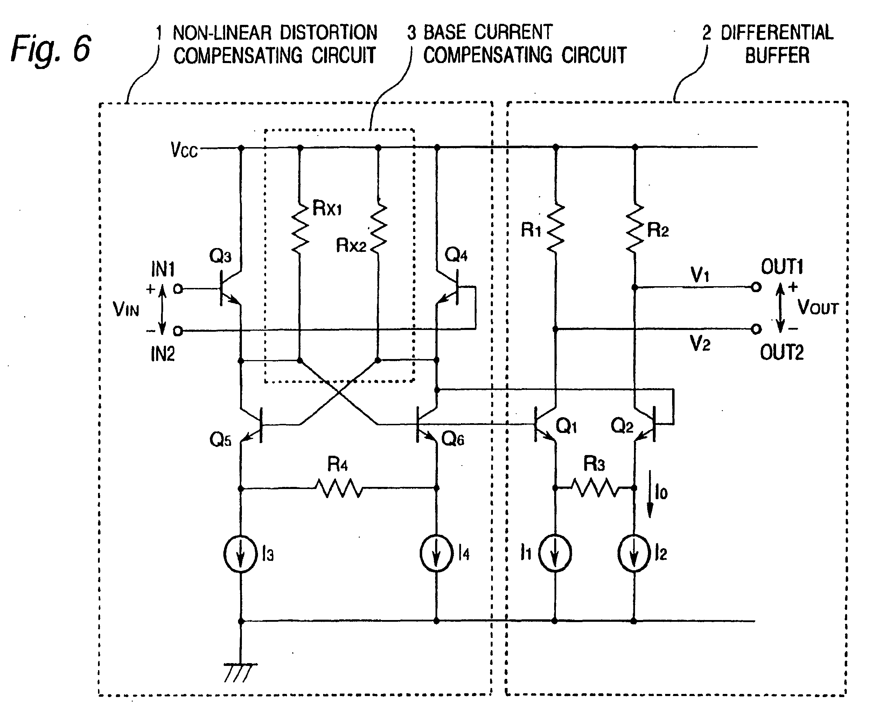

Referring to Fig. 6, there is shown a circuit diagram of a third embodiment of the differential amplifier shown in Fig. 1. In Fig. 6, elements corresponding to those shown in Fig. 1 are given the same Reference Numerals, and explanation will be omitted for simplification of description.

The current sources $I_{X1}$ and $I_{X2}$ of the base current compensating circuit 3 in this third embodiment are constituted of only resistors $R_{X1}$ and $R_{X2}$, respectively. Accordingly, since the base current compensating circuit 3 in the third embodiment has no constant current source, the third embodiment can realize a low power consumption in comparison with the first and second embodiments.

Now, an operation of the third embodiment will be described.

Each of the resistors $R_{X1}$ and $R_{X2}$ can be deemed to be a current source which supplies a current $I_{X\_0}$ when the differential input voltage $V_{IN}$ is 0 (zero) and which has an output resistance $R_X$. Here, $R_X$ is a resistance of the resistors $R_{X1}$ and $R_{X2}$.

Therefore, in the above mentioned equation giving $\Delta V_{BE4}$, if the situation when the differential input voltage $V_{IN}$ is 0 (zero) is considered to be as a reference condition, $\Delta I_X$ is approximately expressed as follows:

$$\Delta I_X = V_{IN} / (2 \times R_X)$$

In addition, since the differential input voltage $V_{IN}$ is approximately equal to $R_3 \times \Delta I_C$, it becomes

$$\Delta I_X = (R_3 \times \Delta I_C) / (2 \times R_X)$$

Accordingly, if the resistance value $R_X$ is determined to fulfill the following relation:

$$I_{X\_0} = \{4/\beta + R_3 / (2 \times R_X)\}\} \times I_{C1\_0}$$

it becomes $\Delta V_{BE4} = \Delta V_{BE1}$

Referring to Fig. 7, there is shown a graph illustrating a relation between a differential input voltage $V_{IN}$ and a non-linear error $V_D$ in the differential amplifier shown in Fig. 6, based on the SPICE simulation.

As shown in Fig. 7, the linearly operating range was extended to $\pm 470$mV. In addition, the gain was 0.9780, which is larger than that obtained in the prior art differential amplifier shown in Fig. 12.

As mentioned above, the differential amplifier in accordance with the present invention includes the base current compensating circuit for supplying at least a portion of each of base currents of the transistors of the second differential pair in the differential buffer and the transistors of the first differential pair in the first group of current sources. With this arrangement, a current for reducing a non-linear distortion caused by base currents of said transistors of said second differential pair in said differential buffer and said transistors of said first differential pair in said first group of current sources, is supplied from the base current compensating circuit to said transistors of said second differential pair in said differential buffer and said transistors of said first differential pair in said first group of current sources, as a base current. Therefore, the differential amplifier operates linearly, and a widened linearly operating range and a high common-mode output potential are simultaneously realized.

The invention has thus been shown and described with reference to the specific embodiments. However, it should be noted that the present invention is in no way limited to the details of the illustrated structures but changes and modifications may be made,

**Claims**

1. A differential amplifier comprising a non-linear distortion compensating circuit (1) and a differential buffer (2), said non-linear distortion compensating circuit (1) including:

   a differential pair constituted of first and second transistors (Q3 and Q4) having collectors connected to a predetermined potential (VCC) and bases connected to a pair of input terminals (IN1 and IN2), respectively, for receiving a differential input voltage (VIN);
   a third transistor (Q5) having a collector connected to an emitter of said first transistor (Q3), a base connected to an emitter of said second transistor (Q4), and an emitter connected through a first constant current source (I3) to the ground;
   a fourth transistor (Q6) having a collector connected to the emitter of said second transistor (Q4), a base connected to the emitter of said first transistor (Q3), and an emitter connected through a second constant current source (I4) to the ground; and
   a first resistor (R4) connected between an emitter of said third transistor (Q5) and an emitter of said fourth transistor (Q6), and

   said differential buffer (2) including a second differential pair constituted of fifth and sixth transistors (Q1 and Q2) having bases connected to the emitter of said first and second transistors (Q3 and Q4) of said non-linear distortion compensating circuit (1), respectively, a collector of said fifth and sixth transistors (Q1 and Q2) constituting a differential output of the differential amplifier, and

**characterized in that** the differential amplifier further includes a base current compensating circuit (3) including:

a third current source (IX1) connected between the emitter of said first transistor (Q3) and said predetermined potential (VCC), for supplying a portion of base currents of said fifth and fourth transistors (Q1 and Q6); and a fourth current source (IX2) connected between the emitter of said second transistor (Q4) and said predetermined potential (VCC), for supplying a portion of base currents of said sixth and third transistors (Q2 and Q5).

2. A differential amplifier claimed in Claim 1 wherein said differential buffer (2) further includes:

a second resistor (R1) connected between the collector of said fifth transistor (Q1) and said predetermined potential (VCC),
a third resistor (R2) connected between the collector of said sixth transistor (Q2) and said predetermined potential (VCC),
a fifth constant current source (I1) connected between the emitter of said fifth transistor (Q1) and the ground;
a sixth constant current source (I2) connected between the emitter of said sixth transistor (Q2) and the ground; and
a fourth resistor (R3) connected between the emitter of said fifth transistor (Q1) and the emitter of said sixth transistor (Q2).

3. A differential amplifier claimed in Claim 1 or 2 wherein said base current compensating circuit (3) is internally provided in said non-linear distortion compensating circuit (1).

4. A differential amplifier claimed in any of Claim 1 to 3 wherein said base current compensating circuit includes:

a differential pair constituted of seventh and eighth transistors (Q11 and Q12) having collectors connected to said predetermined potential (VCC) and bases connected to said pair of input terminals (IN1 and IN2), respectively, an emitter of said seventh and eighth transistors (Q11 and Q12) being connected through seventh and eighth current sources (I7 and I8) to the ground, respectively;
a ninth transistor (Q9) having a base connected to the emitter of said seventh transistor (Q11) and an emitter connected through a ninth current source (I5) to the ground;
a tenth transistor (Q10) having a base connected to the emitter of said eighth transistor (Q12) and an emitter connected through a tenth current source (I6) to the ground;
a fifth resistor (R5) connected between the emitter of said ninth transistor (Q9) and the emitter of said tenth transistor (Q10);
an eleventh transistor (Q7) having an emitter connected to a collector of said ninth transistor (Q9) and a collector connected to said predetermined potential (VCC);
a twelfth transistor (Q8) having an emitter connected to a collector of said tenth transistor (Q10) and a collector connected to said predetermined potential (VCC);
a first current mirror circuit constituted of first and second PMOS transistors (MP1 and MP2) having sources connected to said predetermined potential (VCC), a drain and a gate of said first PMOS transistor (MP1) and a gate of said second PMOS transistor (MP2) being connected to a base of said eleventh transistor (Q7), and a drain of said second PMOS transistor (MP2) being connected to the emitter of said first transistor (Q3), so that said second PMOS transistor (MP2) constitutes said third current source (IX1); and
a second current mirror circuit constituted of third and fourth PMOS transistors (MP3 and MP4) having sources connected to said predetermined potential (VCC), a drain and a gate of said third PMOS transistor (MP3) and a gate of said fourth PMOS transistor (MP4) being connected to a base of said twelfth transistor (Q8), and a drain of said fourth PMOS transistor (MP4) being connected to the emitter of said second transistor (Q4), so that said fourth PMOS transistor (MP4) constitutes said fourth current source (IX2),

whereby currents supplied from said third and fourth current sources (IX1 and IX2) become equal to a sum of base currents of said fifth and fourth transistors (Q1 and Q6) and a sum of base currents of said sixth and third transistors (Q2 and Q5), respectively.

5. A differential amplifier claimed in any of Claim 1 to 3 wherein said base current compensating circuit includes:

a seventh transistor (Q13) having a collector connected to said predetermined potential (VCC) and an emitter connected through a seventh current source (I9) to the ground; and

a current mirror circuit constituted of first, second and third PMOS transistors (MP5, MP6 and MP7) having sources connected to said predetermined potential (VCC), a drain and a gate of said first PMOS transistor (MP5) and a gate of said second and third PMOS transistors (MP6 and MP7) being connected to a base of said seventh transistor (Q13), and a drain of said second PMOS transistor (MP6) being connected to the emitter of said first transistor (Q3) so that said second PMOS transistor (MP6) constituting said third current source (IX1), and a drain of said third PMOS transistor (MP7) being connected to the emitter of said second transistor (Q4), so that said third PMOS transistor (MP7) constitutes said fourth current source (IX2).

6. A differential amplifier claimed in any of Claim 1 to 3 wherein said third current source (IX1) in said base current compensating circuit is a fifth resistor (Rx1) connected between the emitter of said first transistor (Q3) and said predetermined potential (VCC), and said fourth current source (IX2) in said base current compensating circuit is a sixth resistor (Rx2) connected between the emitter of said second transistor (Q4) and said predetermined potential (VCC).

7. A differential amplifier claimed in Claim 1 or 2 wherein said base current compensating circuit includes a pair of resistors provided to comply with said differential emitter follower in said non-linear distortion compensating circuit.

8. A differential amplifier comprising:

a non-linear distortion compensating circuit including a differential emitter follower, and a first group of current sources having a first differential pair of transistors having bases receiving a pair of emitter currents of said differential emitter follower, respectively, so that said first group of current sources are controlled by said pair of emitter currents of said differential emitter follower;
a differential buffer including a second differential pair of transistors having bases receiving signals outputted from said non-linear distortion compensating circuit, respectively, and
a base current compensating circuit for supplying to emitter nodes of said differential emitter follower a current for reducing a non-linear distortion caused by base currents of said transistors of said second differential pair in said differential buffer and said transistors of said first differential pair in said first group of current sources.

9. A differential amplifier claimed in Claim 8 wherein said base current compensating circuit is internally provided in said non-linear distortion compensating circuit.

10. A differential amplifier claimed in Claim 8 or 9 wherein said non-linear distortion compensating circuit includes a second group of current sources controlled to be ceaselessly equal to said base currents of said transistors of said second differential pair in said differential buffer.

11. A differential amplifier claimed in Claim 8 or 9 wherein said base current compensating circuit includes a current mirror circuit for supplying a predetermined base current to said transistors of said second differential pair in said differential buffer.

12. A differential amplifier claimed in Claim 11 wherein said current mirror circuit has a magnifying power predetermined for eliminating a non-linear distortion caused by said base current.

13. A differential amplifier claimed in Claim 8 or 9 wherein said base current compensating circuit supplies a constant current for eliminating a non-linear distortion caused by said base currents of said transistors of said second differential pair in said differential buffer and said transistors of said first differential pair in said first group of current sources.

14. A differential amplifier claimed in Claim 8 or 9 wherein said base current compensating circuit includes a pair of resistors provided to comply with said differential emitter follower in said non-linear distortion compensating circuit.

**Patentansprüche**

1. Differenzverstärker, der eine Schaltung (1) zum Kompensieren einer nichtlinearen Verzerrung und einen differentiellen Puffer (2) umfasst,
wobei die Schaltung (1) zum Kompensieren einer nichtlinearen Verzerrung umfasst:

ein differentielles Paar, das aus einem ersten und aus einem zweiten Transistor (Q3 und Q4) gebildet ist, die Kollektoren, die mit einem vorgegebenen Potential (VCC) verbunden sind, und Basen, die entsprechend mit einem Paar Eingangsanschlüsse (IN1 bzw. IN2) verbunden sind, um eine differentielle Eingangsspannung (VIN) zu empfangen, besitzen;

einen dritten Transistor (Q5), der einen Kollektor, der mit einem Emitter des ersten Transistors (Q3) verbunden ist, eine Basis, die mit einem Emitter des zweiten Transistors (Q4) verbunden ist, und einen Emitter, der über eine erste Konstantstromquelle (I3) mit Masse verbunden ist, besitzt;

einen vierten Transistor (Q6), der einen Kollektor, der mit dem Emitter des zweiten Transistors (Q4) verbunden ist, eine Basis, die mit dem Emitter des ersten Transistors (Q3) verbunden ist, und einen Emitter, der über eine zweite Konstantstromquelle (I4) mit Masse verbunden ist, besitzt; und

einen ersten ohmschen Widerstand (R4), der zwischen einen Emitter des dritten Transistors (Q5) und einen Emitter des vierten Transistors (Q6) geschaltet ist, und

wobei der differentielle Puffer (2) ein zweites differentielles Paar enthält, das aus einem fünften und aus einem sechsten Transistor (Q1 und Q2) gebildet ist, deren Basen mit dem Emitter des ersten bzw. des zweiten Transistors (Q3 bzw. Q4) der Schaltung (1) zum Kompensieren einer nichtlinearen Verzerrung verbunden sind, wobei die Kollektoren des fünften und des sechsten Transistors (Q1 bzw. Q2) einen differentiellen Ausgang des Differenzverstärkers bilden, und

**dadurch gekennzeichnet, dass** der Differenzverstärker ferner eine Basisstrom-Kompensationsschaltung (3) enthält, die umfasst:

eine dritte Stromquelle (IX1), die zwischen den Emitter des ersten Transistors (Q3) und das vorgegebene Potential (VCC) geschaltet ist, um einen Teil der Basisströme des fünften und des vierten Transistors (Q1 bzw. Q6) zu liefern; und

eine vierte Stromquelle (IX2), die zwischen den Emitter des zweiten Transistors (Q4) und das vorgegebene Potential (VCC) geschaltet ist, um einen Teil der Basisströme des sechsten und des dritten Transistors (Q2 bzw. Q5) zu liefern.

2. Differenzverstärker nach Anspruch 1, bei dem der differentielle Puffer (2) ferner umfasst:

einen zweiten ohmschen Widerstand (R1), der zwischen den Kollektor des fünften Transistors (Q1) und das vorgegebene Potential (VCC) geschaltet ist,

einen dritten ohmschen Widerstand (R2), der zwischen den Kollektor des sechsten Transistors (Q2) und das vorgegebene Potential (VCC) geschaltet ist,

eine fünfte Konstantstromquelle (I1), die zwischen den Emitter des fünften Transistors (Q1) und Masse geschaltet ist;

eine sechste Konstantstromquelle (I2), die zwischen den Emitter des sechsten Transistors (Q2) und Masse geschaltet ist; und

einen vierten ohmschen Widerstand (R3), der zwischen den Emitter des fünften Transistors (Q1) und den Emitter des sechsten Transistors (Q2) geschaltet ist.

3. Differenzverstärker nach Anspruch 1 oder 2, bei dem die Basisstrom-Kompensationsschaltung (3) in der Schaltung (1) zum Kompensieren einer nichtlinearen Verzerrung intern vorgesehen ist.

4. Differenzverstärker nach einem der Ansprüche 1 bis 3, bei dem die Basisstrom-Kompensationsschaltung enthält:

ein differentielles Paar, das aus einem siebten und aus einem achten Transistor (Q11 bzw. Q12) gebildet ist, die Kollektoren, die mit dem vorgegebenen Potential (VCC) verbunden sind, und Basen, die entsprechend mit dem Paar Eingangsanschlüsse (IN1 bzw. IN2) verbunden sind, besitzen, wobei die Emitter des siebten und des achten Transistors (Q11 bzw. Q12) über eine siebte bzw. eine achte Stromquelle (I7 und I8) mit Masse verbunden sind;

einen neunten Transistor (Q9), der eine Basis, die mit dem Emitter des siebten Transistors (Q11) verbunden ist, und einen Emitter, der über eine neunte Stromquelle (15) mit Masse verbunden ist, besitzt;

einen zehnten Transistor (Q10), der eine Basis, die mit dem Emitter des achten Transistors (Q12) verbunden ist, und einen Emitter, der über eine zehnte Stromquelle (16) mit Masse verbunden ist, besitzt;

einen fünften ohmschen Widerstand (R5), der zwischen den Emitter des neunten Transistors (Q9) und den Emitter des zehnten Transistors (Q10) geschaltet ist;

einen elften Transistor (Q7), der einen Emitter, der mit einem Kollektor des neunten Transistors (Q9) verbunden ist, und einen Kollektor, der mit dem vorgegebenen Potential (VCC) verbunden ist, besitzt;

einen zwölften Transistor (Q8), der einen Emitter, der mit einem Kollektor des zehnten Transistors (Q10) verbunden ist, und einen Kollektor, der mit dem vorgegebenen Potential (VCC) verbunden ist, besitzt;

eine erste Stromspiegelschaltung, die aus einem ersten und einem zweiten PMOS-Transistor (MP1 bzw. MP2) gebildet ist, deren Sources mit dem vorgegebenen Potential (VCC) verbunden sind, wobei ein Drain und ein Gate des ersten PMOS-Transistors (MP1) und ein Gate des zweiten PMOS-Transistors (MP2) mit einer Basis des elften Transistors (Q7) verbunden sind und ein Drain des zweiten PMOS-Transistors (MP2) mit dem Emitter des ersten Transistors (Q3) verbunden ist, so dass der zweite PMOS-Transistor (MP2) die dritte Stromquelle (IX1) bildet; und

eine zweite Stromspiegelschaltung, die aus einem dritten und aus einem vierten PMOS-Transistor (MP3 bzw. MP4) gebildet ist, deren Sources mit dem vorgegebenen Potential (VCC) verbunden sind, wobei ein Drain und ein Gate des dritten PMOS-Transistors (MP3) und ein Gate des vierten PMOS-Transistors (MP4) mit einer Basis des zwölften Transistors (Q8) verbunden sind und ein Drain des vierten PMOS-Transistors (MP4) mit dem Emitter des zweiten Transistors (Q4) verbunden ist, so dass der vierte PMOS-Transistor (MP4) die vierte Stromquelle (IX2) bildet,

wobei Ströme, die von der dritten und von der vierten Stromquelle (IX1 bzw. IX2) geliefert werden, gleich einer Summe von Basisströmen des fünften und des sechsten Transistors (Q1 bzw. Q6) bzw. einer Summe von Basisströmen des sechsten und des dritten Transistors (Q2 bzw. Q5) sind.

5. Differenzverstärker nach einem der Ansprüche 1 bis 3, bei dem die Basisstrom-Kompensationsschaltung umfasst:

einen siebten Transistor (Q13), der einen Kollektor, der mit dem vorgegebenen Potential (VCC) verbunden ist, und einen Emitter, der über eine siebte Stromquelle (I9) mit Masse verbunden ist, besitzt; und

eine Stromspiegelschaltung, die aus einem ersten, einem zweiten und einem dritten PMOS-Transistor (MP5, MP6 bzw. MP7) gebildet ist, deren Sources mit dem vorgegebenen Potential (VCC) verbunden sind, wobei ein Drain und ein Gate des ersten PMOS-Transistors (MP5) und ein Gate des zweiten und des dritten PMOS-Transistors (MP6 und MP7) mit einer Basis des siebten Transistors (Q13) verbunden sind und ein Drain des zweiten PMOS-Transistors (MP6) mit dem Emitter des ersten Transistors (Q3) verbunden ist, so dass der zweite PMOS-Transistor (MP6) die dritte Stromquelle (IX1) bildet und ein Drain des dritten PMOS-Transistors (MP7) mit dem Emitter des zweiten Transistors (Q4) verbunden ist, so dass der dritte PMOS-Transistor (MP7) die vierte Stromquelle (IX2) bildet.

6. Differenzverstärker nach einem der Ansprüche 1 bis 3, bei dem die dritte Stromquelle (IX1) in der Basisstrom-Kompensationsschaltung ein fünfter ohmscher Widerstand (Rx1) ist, der zwischen den Emitter des ersten Transistors (Q3) und das vorgegebene Potential (VCC) geschaltet ist, und bei dem die vierte Stromquelle (IX2) in der Basisstrom-Kompensationsschaltung ein sechster ohmscher Widerstand (Rx2) ist, der zwischen den Emitter des zweiten Transistors (Q4) und das vorgegebene Potential (VCC) geschaltet ist.

7. Differenzverstärker nach Anspruch 1 oder 2, bei dem die Basisstrom-Kompensationsschaltung ein Paar ohmscher Widerstände umfasst, die dazu vorgesehen sind, dem differentiellen Emitterfolger in der Schaltung zur Kompensation einer nichtlinearen Verzerrung zu folgen.

8. Differenzverstärker, der umfasst:

eine Schaltung zum Kompensieren einer nichtlinearen Verzerrung, die einen differentiellen Emitterfolger und eine erste Gruppe von Stromquellen umfasst, die ein erstes differentielles Paar von Transistoren besitzt, deren Basen entsprechend ein Paar Emitterströme des differentiellen Emitterfolgers empfangen, so dass die erste Gruppe von Stromquellen durch das Paar Emitterströme des differentiellen Emitterfolgers gesteuert wird;

einen differentiellen Puffer, der ein zweites differentielles Paar Transistoren enthält, deren Basen jeweils Signale empfangen, die von der Schaltung zur Kompensation einer nichtlinearen Verzerrung ausgegeben werden, und

eine Basisstrom-Kompensationsschaltung, die an Emitterknoten des differentiellen Emitterfolgers einen Strom liefert, um eine nichtlineare Verzerrung zu verringern, die durch Basisströme der Transistoren des zweiten differentiellen Paars in dem differentiellen Puffer und der Transistoren des ersten differentiellen Paars in der ersten Gruppe von Stromquellen hervorgerufen werden.

9. Differenzverstärker nach Anspruch 8, bei dem die Basisstrom-Kompensationsschaltung in der Schaltung zur Kompensation einer nichtlinearen Verzerrung intern vorgesehen ist.

10. Differenzverstärker nach Anspruch 8 oder 9, bei dem die Schaltung zur Kompensation einer nichtlinearen Verzerrung eine zweite Gruppe Stromquellen umfasst, die so gesteuert werden, dass sie ununterbrochen gleich den Basisströmen der Transistoren des zweiten differentiellen Paars in dem differentiellen Puffer sind.

11. Differenzverstärker nach Anspruch 8 oder 9, bei dem die Basisstrom-Kompensationsschaltung eine Stromspiegelschaltung umfasst, um an die Transistoren des zweiten differentiellen Paars in dem differentiellen Puffer einen vorgegebenen Basisstrom zu liefern.

12. Differenzverstärker nach Anspruch 11, bei dem die Stromspiegelschaltung eine vorgegebene Vergrößerung besitzt, um eine durch den Basisstrom erzeugte nichtlineare Verzerrung zu beseitigen.

13. Differenzverstärker nach Anspruch 8 oder 9, bei dem die Basisstrom-Kompensationsschaltung einen konstanten Strom liefert, um eine nichtlineare Verzerrung zu beseitigen, die durch die Basisströme der Transistoren des zweiten differentiellen Paars in dem differentiellen Puffer und der Transistoren des ersten differentiellen Paars in der ersten Gruppe von Stromquellen hervorgerufen wird.

14. Differenzverstärker nach Anspruch 8 oder 9, bei dem die Basisstrom-Kompensationsschaltung ein Paar ohmscher Widerstände umfasst, die so vorgesehen sind, dass sie dem differentiellen Emitterfolger in der Schaltung zur Kompensation einer nichtlinearen Verzerrung folgen.

## Revendications

1. Amplificateur différentiel comprenant un circuit de compensation de distorsion non linéaire (1) et un tampon différentiel (2),

   ledit circuit de compensation de distorsion non linéaire (1) comprenant :

   une paire différentielle constituée d'un premier transistor (Q3) et d'un deuxième transistor (Q4) ayant des collecteurs connectés à un potentiel prédéterminé (VCC) et des bases connectées à une paire de bornes d'entrée (IN1 et IN2), respectivement, pour recevoir une tension d'entrée différentielle (VIN) ;
   un troisième transistor (Q5) ayant un collecteur connecté à un émetteur dudit premier transistor (Q3), une base connectée à un émetteur dudit deuxième transistor (Q4), et un émetteur connecté à travers une première source de courant constant (I3) à la terre ;
   un quatrième transistor (Q6) ayant un collecteur connecté à l'émetteur dudit deuxième transistor (Q4), une base connectée à l'émetteur dudit premier transistor (Q3), et un émetteur connecté à travers une deuxième source de courant constant (I4) à la terre ; et
   une première résistance (R4) connectée entre un émetteur dudit troisième transistor (Q5) et un émetteur dudit quatrième transistor (Q6), et

   ledit tampon différentiel (2) comprenant une deuxième paire différentielle constituée d'un cinquième transistor (Q1) et d'un sixième transistor (Q2) ayant des bases connectées à l'émetteur dudit premier transistor (Q3) et dudit deuxième transistor (Q4) dudit circuit de compensation de distorsion non linéaire (1), respectivement, un collecteur dudit cinquième transistor (Q1) et dudit sixième transistor (Q2) constituant une sortie différentielle de l'amplificateur différentiel, et
   **caractérisé en ce que** l'amplificateur différentiel comprend en outre un circuit de compensation de courant de base (3) comprenant :

   une troisième source de courant (IX1) connectée entre l'émetteur dudit premier transistor (Q3) et ledit potentiel prédéterminé (VCC), pour fournir une partie des courants de base dudit cinquième transistor (Q1) et dudit quatrième transistor (Q6) ; et
   une quatrième source de courant (IX2) connectée entre l'émetteur dudit deuxième transistor (Q4) et ledit potentiel prédéterminé (VCC), pour fournir une partie des courants de base dudit sixième transistor (Q2) et dudit troisième transistor (Q5).

2. Amplificateur différentiel selon la revendication 1 dans lequel ledit tampon différentiel (2) comprend en outre :

une deuxième résistance (R1) connectée entre le collecteur dudit cinquième transistor (Q1) et ledit potentiel prédéterminé (VCC),
une troisième résistance (R2) connectée entre le collecteur dudit sixième transistor (Q2) et ledit potentiel prédéterminé (VCC),
une cinquième source de courant constant (I1) connectée entre l'émetteur dudit cinquième transistor (Q1) et la terre ;
une sixième source de courant constant (I2) connectée entre l'émetteur dudit sixième transistor (Q2) et la terre ; et
une quatrième résistance (R3) connectée entre l'émetteur dudit cinquième transistor (Q1) et l'émetteur dudit sixième transistor (Q2).

3. Amplificateur différentiel selon la revendication 1 ou 2 dans lequel ledit circuit de compensation de courant de base (3) est fourni en interne dans ledit circuit de compensation de distorsion non linéaire (1).

4. Amplificateur différentiel selon l'une quelconque des revendications 1 à 3, dans lequel ledit circuit de compensation de courant de base comprend :

une paire différentielle constituée d'un septième transistor (Q11) et d'un huitième transistor (Q12) ayant des collecteurs connectés au dit potentiel prédéterminé (VCC) et des bases connectées à ladite paire de bornes d'entrée (IN1 et IN2), respectivement, un émetteur dudit septième transistor (Q11) et dudit huitième transistor (Q12) étant connecté à travers la septième source de courant (I7) et la huitième source de courant (18) à la terre, respectivement ;
un neuvième transistor (Q9) ayant une base connectée à l'émetteur dudit septième transistor (Q11) et un émetteur connecté à travers une neuvième source de courant (I5) à la terre ;
un dixième transistor (Q10) ayant une base connectée à l'émetteur dudit huitième transistor (Q12) et un émetteur connecté à travers une dixième source de courant (I6) à la terre ;
une cinquième résistance (R5) connectée entre l'émetteur dudit neuvième transistor (Q9) et l'émetteur dudit dixième transistor (Q10) ;
un onzième transistor (Q7) ayant un émetteur connecté à un collecteur dudit neuvième transistor (Q9) et un collecteur connecté au dit potentiel prédéterminé (VCC) ;
un douzième transistor (Q8) ayant un émetteur connecté à un collecteur dudit dixième transistor (Q10) et un collecteur connecté au dit potentiel prédéterminé (VCC) ;
un premier circuit miroir de courant constitué d'un premier transistor PMOS (MP1) et d'un deuxième transistor PMOS (MP2) ayant des sources connectées au dit potentiel prédéterminé (VCC), un drain et une porte dudit premier transistor PMOS (MP1) et une porte dudit deuxième transistor PMOS (MP2) étant connectés à une base dudit onzième transistor (Q7), et un drain dudit deuxième transistor PMOS (MP2) étant connecté à l'émetteur dudit premier transistor (Q3), de sorte que ledit deuxième transistor PMOS (MP2) constitue ladite troisième source de courant (IX1) ; et
un deuxième circuit miroir de courant constitué d'un troisième transistor PMOS (MP3) et d'un quatrième transistor PMOS (MP4) ayant des sources connectées au dit potentiel prédéterminé (VCC), un drain et une porte dudit troisième transistor PMOS (MP3) et une porte dudit quatrième transistor PMOS (MP4) étant connectés à une base dudit douzième transistor (Q8), et un drain dudit quatrième transistor PMOS (MP4) étant connecté à l'émetteur dudit deuxième transistor (Q4), de sorte que ledit quatrième transistor PMOS (MP4) constitue ladite quatrième source de courant (IX2),

moyennant quoi les courants fournis à partir de la troisième source de courant (IX1) et de la quatrième source de courant (IX2) deviennent égaux à une somme des courants de base dudit cinquième transistor (Q1) et dudit quatrième transistor (Q6) et à une somme des courants de base dudit sixième transistor (Q2) et dudit troisième transistor (Q5) respectivement.

5. Amplificateur différentiel selon l'une quelconque des revendications 1 à 3 dans lequel ledit circuit de compensation de courant de base comprend :

un septième transistor (Q13) ayant un collecteur connecté au dit potentiel prédéterminé (VCC) et un émetteur connecté à travers une septième source de courant (I8) à la terre ; et
un circuit miroir de courant constitué du premier transistor PMOS (MP5), du deuxième transistor PMOS (MP6) et d'un troisième transistor PMOS (MP7) ayant des sources connectées au dit potentiel prédéterminé (VCC), un drain et une porte dudit premier transistor PMOS (MP5) et une porte dudit deuxième transistor PMOS (MP6) et dudit troisième transistor PMOS (MP7) étant connectés à une base dudit septième transistor (Q13), et un drain dudit deuxième transistor PMOS (MP6) étant connecté à l'émetteur dudit premier transistor (Q3) de sorte que ledit deuxième transistor PMOS (MP6) constitue ladite troisième source de courant (IX1), et un drain dudit troisième transistor PMOS (MP7) étant connectés à l'émetteur dudit deuxième transistor (Q4) de sorte que le troisième transistor PMOS (MP7) constitue ladite quatrième source de courant (I2).

6. Amplificateur différentiel selon l'une quelconque des revendications 1 à 3, dans lequel ladite troisième source de courant (IX1) dans ledit circuit de compensation de courant de base est une cinquième résistance (Rx1) connectée entre l'émetteur dudit premier transistor (Q3) et ledit potentiel prédéterminé (VCC), et ladite quatrième source de courant (IX2) dans ledit circuit de compensation de courant de base est une sixième résistance (Rx2) connectée entre l'émetteur dudit deuxième transistor (Q4) et ledit potentiel prédéterminé (VCC).

7. Amplificateur différentiel selon la revendication 1 ou 2 dans lequel ledit circuit de compensation de courant de base comprend une paire de résistances fournies pour se conformer au dit suiveur d'émetteur différentiel dans ledit circuit de compensation de distorsion non linéaire.

8. Amplificateur différentiel comprenant :

   un circuit de compensation de distorsion non linéaire comprenant un suiveur d'émetteur différentiel, et un premier groupe de sources de courant ayant une première paire différentielle de transistors ayant des bases recevant une paire de courants d'émetteur dudit suiveur d'émetteur différentiel, respectivement, de sorte que ledit premier groupe de sources de courant soit contrôlé par ladite paire de courants d'émetteur dudit suiveur d'émetteur différentiel :

      un tampon différentiel comprenant une deuxième paire différentielle de transistors ayant des bases recevant des signaux délivrés à partir dudit circuit de compensation de distorsion non linéaire, respectivement, et
      un circuit de compensation de courant de base pour fournir à des noeuds d'émetteur dudit suiveur d'émetteur différentiel un courant pour réduire une distorsion non linéaire provoquée par des courants de base desdits transistors de ladite deuxième paire différentielle dans ledit tampon différentiel et lesdits transistors de ladite première paire différentielle dans ledit premier groupe de sources de courant.

9. Amplificateur différentiel selon la revendication 8, dans lequel ledit circuit de compensation de courant de base est fourni en interne dans ledit circuit de compensation de distorsion non linéaire.

10. Amplificateur différentiel selon la revendication 8 ou 9, dans lequel ledit circuit de compensation de distorsion non linéaire comprend un deuxième groupe de sources de courant contrôlé pour être continuellement égal aux dits courants de base desdits transistors de ladite deuxième paire différentielle dans ledit tampon différentiel.

11. Amplificateur différentiel selon la revendication 8 ou 9, dans lequel ledit circuit de compensation de courant de base comprend un circuit de miroir de courant pour fournir un courant de base prédéterminé aux dits transistors de ladite deuxième paire différentielle dans ledit tampon différentiel.

12. Amplificateur différentiel selon la revendication 11 dans lequel ledit circuit miroir de courant a un grossissement prédéterminé pour éliminer une distorsion non linéaire provoquée par ledit courant de base.

13. Amplificateur différentiel selon la revendication 8 ou 9, dans lequel ledit circuit de compensation de courant de base fournit un courant constant pour éliminer une distorsion non linéaire provoquée par lesdits courants de base desdits transistors de ladite deuxième paire différentielle dans ledit tampon différentiel et lesdits transistors de ladite première paire différentielle dans ledit premier groupe de sources de courant.

14. Amplificateur différentiel selon la revendication 8 ou 9, dans lequel ledit circuit de compensation de courant de base comprend une paire de résistances fournies pour se conformer au dit suiveur d'émetteur différentiel dans ledit circuit de compensation de distorsion non linéaire.

Fig. 1

1 NON-LINEAR DISTORTION COMPENSATING CIRCUIT  3 BASE CURRENT COMPENSATING CIRCUIT  2 DIFFERENTIAL BUFFER

Fig. 2

1 NON-LINEAR DISTORTION COMPENSATING CIRCUIT

3 BASE CURRENT COMPENSATING CIRCUIT

2 DIFFERENTIAL BUFFER

EP 0 910 164 B1

VD-VIN

Fig. 3

DIFFERENTIAL INPUT VOLTAGE
VIN ( V )

NON-LINEAR ERROR
VD ( mV )

Fig. 4

1 NON-LINEAR DISTORTION COMPENSATING CIRCUIT

3 BASE CURRENT COMPENSATING CIRCUIT

2 DIFFERENTIAL BUFFER

EP 0 910 164 B1

Fig. 5

VD-VIN

DIFFERENTIAL INPUT VOLTAGE VIN ( V )

NON-LINEAR ERROR VD ( mV )

Fig. 6

1 NON-LINEAR DISTORTION COMPENSATING CIRCUIT  3 BASE CURRENT COMPENSATING CIRCUIT  2 DIFFERENTIAL BUFFER

EP 0 910 164 B1

Fig. 7

VD-VIN

NON-LINEAR ERROR
VD (mV)

DIFFERENTIAL INPUT VOLTAGE
VIN ( V )

## Fig. 8
### PRIOR ART

*Fig. 9* PRIOR ART

VD-VIN

NON-LINEAR ERROR
VD ( mV )

DIFFERENTIAL INPUT VOLTAGE
VIN ( V )

# Fig. 10
## PRIOR ART

Fig. 11 PRIOR ART

VD-VIN

EP 0 910 164 B1

Fig. 12
PRIOR ART

101 NON-LINEAR DISTORTION
COMPENSATING CIRCUIT

102 DIFFERENTIAL
BUFFER

EP 0 910 164 B1

Fig. 13 PRIOR ART

VD-VIN

NON-LINEAR ERROR VD ( mV )

DIFFERENTIAL INPUT VOLTAGE
VIN ( V )

EP 0 910 164 B1